# FASCICULE DE BREVET EUROPEEN

(11) **EP 3 549 161 B1**
(45) Date de publication et mention de la délivrance du brevet: **27.09.2023**
(21) Numéro de dépôt: 17816922.3
(22) Date de dépôt: 23.11.2017
(51) Int. Cl.: H01L 21/762

(54) **CIRCUIT ELECTRONIQUE COMPRENANT DES TRANCHEES D'ISOLATION ELECTRIQUE**
ELEKTRONISCHE SCHALTUNG MIT ELEKTRISCHEN ISOLIERENDEN GRÄBEN
ELECTRONIC CIRCUIT COMPRISING ELECTRICAL INSULATION TRENCHES

(30) Priorité: 29.11.2016 FR 1661611
(43) Date de publication de la demande: 09.10.2019
(73) Titulaire: Commissariat à l'énergie atomique et aux énergies alternatives, 75015 Paris (FR)
(72) Inventeur: GASSE, Adrien, 38180 Seyssins (FR); JARJAYES, Sylvie, 38360 Sassenage (FR); VOLPERT,Marion, 38360 Sassenage (FR)
(74) Mandataire: Cabinet Beaumont
(86) Numéro de dépôt international: PCT/FR2017/053240
(87) Numéro de publication internationale: WO 2018/100273

(56) Documents cités:
- EP-A1- 2 466 634
- EP-A1- 2 466 634
- US-A1- 2012 153 492
- US-A1- 2012 153 492
- US-A1- 2015 118 823
- US-A1- 2015 118 823

## Description

### Domaine

La présente demande concerne un circuit électronique comprenant des tranchées d'isolation électrique.

### Exposé de l'art antérieur

De façon générale, un circuit électronique comprend un substrat semiconducteur dans lequel et sur lequel sont formés des composants électroniques. Pour certaines applications, il est souhaitable d'isoler électriquement les unes des autres différentes portions du substrat semiconducteur. Ceci peut être obtenu en formant dans le substrat des tranchées isolantes électriquement qui s'étendent sur la totalité de l'épaisseur du substrat et qui divisent le substrat en portions isolées électriquement les unes des autres.

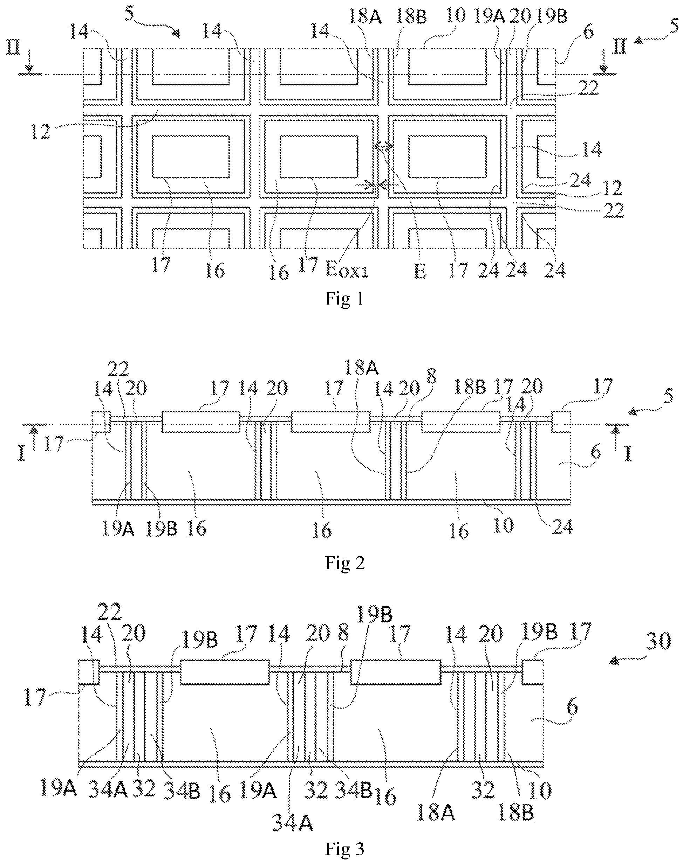

Les figures 1 et 2 sont des vues en coupe d'un exemple de circuit électronique 5, représentant l'art antérieur.

La figure 1 est une vue en coupe de la figure 2 selon la ligne I-I et la figure 2 est une vue en coupe de la figure 1 selon la ligne II-II. Le circuit électronique 5 comprend un substrat semiconducteur 6 ayant des faces 8, 10 opposées et comprend en outre, dans le substrat 6, des tranchées d'isolation électrique 12, 14 qui s'entrecroisent et délimitent des portions 16 du substrat 6. Des composants électroniques 17, représentés de façon schématique sur les figures 1 et 2 par des rectangles, sont formés dans les portions 16 et/ou sur les portions 16. Il s'agit par exemple de transistors à effet de champ à grille métal-oxyde (transistors MOS), de diodes, de diodes électroluminescentes ou de photodiodes.

Les tranchées 12 s'étendent en vue de dessus selon une première direction et les tranchées 14 s'étendent en vue de dessus selon une deuxième direction inclinée par rapport à la première direction, par exemple perpendiculaire à la première direction. Les tranchées 12, 14 ont sensiblement la forme de bandes en vue de dessus. Les tranchées 12, 14 s'étendent dans le substrat 6 depuis la face 8 sur une partie ou sur la totalité de l'épaisseur du substrat 6.

A titre d'exemple, chaque tranchée 12, 14 comprend deux parois latérales 18A, 18B opposées sensiblement planes, par exemple sensiblement parallèles, recouvertes d'une portion isolante électriquement 19A, 19B d'épaisseur Eₒₓ₁, mesurée dans un plan parallèle à la face 8, le coeur 20 de la tranchée 12, 14 étant rempli d'un matériau de remplissage, par exemple un matériau semiconducteur. La portion isolante 19A, 19B peut avoir une épaisseur sensiblement constante. A titre de variante, l'épaisseur de la portion isolante 19A, 19B peut ne pas être constante. Dans ce cas, l'épaisseur Eₒₓ₁ correspond à l'épaisseur minimale de la portion isolante 19A, 19B. On appelle dimension latérale E, également appelée indifféremment largeur ou épaisseur, de la tranchée 12, 14 la distance entre les deux parois latérales 18A, 18B. A titre de variante, les parois latérales 18A, 18B peuvent être sensiblement inclinées l'une par rapport à l'autre, les parois latérales 18A, 18B se rapprochant par exemple l'une de l'autre en s'éloignant de la face 8. Dans ce cas, l'épaisseur E de la tranchée 12, 14 correspond à la distance moyenne séparant les deux parois latérales 18A, 18B.

Le circuit électronique 5 comprend, en outre, une couche isolante électriquement 22 ou un empilement de couches isolantes électriquement sur la face 8 et une couche isolante électriquement 24 ou un empilement de couches isolantes électriquement sur la face 10. Des plots de contact, non représentés, peuvent être prévus du côté de la face 10, au travers de la couche isolante 24 au contact des portions 16 de substrat.

L'épaisseur E et l'épaisseur Eₒₓ₁ sont déterminées en fonction de la tenue en tension souhaitée pour la tranchée 12, 14, c'est-à-dire la tension minimale, appelée tension de claquage, appliquée entre deux portions 16 adjacentes du substrat 6 pour laquelle la tranchée 12, 14 devient conductrice électriquement. Les dimensions E et Eₒₓ₁ sont généralement déterminées par simulation. Selon les applications visées, les tranchées 12, 14 doivent résister à des tensions pouvant être supérieures à 100 V, voire à plusieurs centaines de volts, par exemple 500 V.

Une possibilité pour augmenter la tenue en tension de la tranchée 12, 14 serait d'augmenter l'épaisseur Eₒₓ₁ de la portion isolante 19A, 19B. Toutefois, lorsque l'épaisseur Eₒₓ₁ augmente, des contraintes mécaniques apparaissent dans le circuit 5, notamment en raison du coefficient de dilatation du matériau isolant composant les portions isolantes 19A, 19B qui est différent du coefficient de dilatation des matériaux adjacents.

Il serait souhaitable d'augmenter la tenue en tension de la tranchée 12, 14 sans augmenter l'épaisseur Eₒₓ₁ de la portion isolante 19A, 19B.

Le document US 2015/118823 A1 se rapporte à un circuit électronique sur un substrat comprenant des portions électriquement isolées, les dernières étant formées par des tranches d'isolation remplies de trois couches de matériaux isolants. 1

### Résumé

Un objet d'un mode de réalisation est de prévoir un circuit électronique comprenant des tranchées d'isolation électrique palliant tout ou partie des inconvénients des tranchées existantes.

Un autre objet d'un mode de réalisation est que la tension de claquage des tranchées d'isolation électrique soit augmentée.

Un autre objet d'un mode de réalisation est que le procédé de fabrication des tranchées d'isolation électrique comprenne un nombre réduit d'étapes supplémentaires par rapport à un procédé de fabrication de tranchées d'isolation électrique classiques.

L'invention prévoit un circuit électronique comprenant un substrat semiconducteur ayant des première et deuxième faces opposées et des tranchées d'isolation électrique s'étendant dans le substrat depuis la première face jusqu'à la deuxième face, chaque tranchée séparant des première et deuxième portions du substrat, chaque tranchée comprenant :
au moins des première et deuxième portions isolantes électriquement d'un premier matériau isolant électriquement s'étendant de la première face à la deuxième face,
des première et deuxième portions intermédiaires, s'étendant de la première face à la deuxième face, en un premier matériau de remplissage différent du premier matériau isolant électriquement, et
une troisième portion isolante électriquement, s'étendant de la première face à la deuxième face, du premier matériau isolant électriquement ou d'un deuxième matériau isolant électriquement différent du premier matériau isolant électriquement,
la première portion isolante électriquement étant en contact avec la première portion intermédiaire, la deuxième portion isolante électriquement étant en contact avec la deuxième portion intermédiaire, et la troisième portion isolante électriquement étant interposée entre les première et deuxième portions intermédiaires.

Selon un mode de réalisation, chaque tranchée comprend en outre :
une quatrième portion isolante électriquement, s'étendant de la première face à la deuxième face, du même matériau que la troisième portion isolante électriquement, et
au moins une troisième portion intermédiaire, s'étendant de la première face à la deuxième face, du premier matériau de remplissage ou d'un deuxième matériau de remplissage différent du premier matériau de remplissage, la troisième portion isolante électriquement étant en contact avec la première portion intermédiaire, la quatrième portion isolante électriquement étant en contact avec la deuxième portion intermédiaire, et la troisième portion intermédiaire étant interposée entre les troisième et quatrième portions isolantes électriquement.

Selon un mode de réalisation, chaque tranchée comprend en outre :
une quatrième portion intermédiaire, s'étendant de la première face à la deuxième face, du même matériau que la troisième portion intermédiaire, et
au moins une cinquième portion isolante électriquement, s'étendant de la première face à la deuxième face, du premier matériau isolant électriquement, du deuxième matériau isolant électriquement ou d'un troisième matériau isolant électriquement différent des premier et deuxième matériaux isolants électriquement, la troisième portion intermédiaire étant en contact avec la troisième portion isolante électriquement, la quatrième portion intermédiaire étant en contact avec la quatrième portion isolante électriquement, et la cinquième portion isolante électriquement étant interposée entre les troisième et quatrième portions intermédiaires.

Selon un mode de réalisation, le premier matériau isolant électriquement est choisi dans le groupe comprenant l'oxyde de silicium, le nitrure de silicium, l'oxynitrure de silicium ou est un matériau ayant une constante diélectrique inférieure, d'au moins 30 %, à la constante diélectrique de l'oxyde de silicium, notamment le dioxyde de silicium dopé au fluor, le dioxyde de silicium dopé au carbone, le dioxyde de silicium poreux ou le dioxyde de silicium dopé au carbone poreux.

Selon un mode de réalisation, le premier matériau de remplissage est choisi parmi le groupe comprenant le silicium, le germanium, le carbure de silicium, les composés III-V, les composés II-VI, le tungstène, le cuivre, les verres à base d'oxydes, les matériaux à base organique ou un mélange d'au moins deux de ces composés.

Les tranchées délimitent des rangées de portions du substrat.

Selon un mode de réalisation, l'épaisseur du substrat est comprise entre 2 µm et 500 µm.

Selon un mode de réalisation, l'épaisseur des première, deuxième et troisième portions isolantes électriquement est comprise entre 10 nm et 500 nm.

Selon un mode de réalisation, l'épaisseur des première et deuxième portions intermédiaires est comprise entre 235 nm et 2000 nm.

L'invention prévoit également un procédé de fabrication d'un circuit électronique, comprenant les étapes successives suivantes :
prévoir un substrat semiconducteur ayant des première et deuxième faces opposées ;
former des ouvertures dans le substrat depuis la première face sur une partie de l'épaisseur du substrat ;
déposer une première couche isolante électriquement d'un premier matériau isolant électriquement au moins dans chaque ouverture ;
déposer une première couche intermédiaire d'un premier matériau de remplissage différent du premier matériau isolant électriquement au moins dans chaque ouverture au contact de la première couche isolante électriquement ;
déposer une deuxième couche isolante électriquement du premier matériau isolant électriquement ou d'un deuxième matériau isolant électriquement différent du premier matériau isolant électriquement au moins dans chaque ouverture au contact de la première couche intermédiaire ; et
amincir le substrat par la deuxième face pour rapprocher la deuxième face de la première face jusqu'à atteindre au moins la deuxième couche isolante électriquement, délimitant ainsi des tranchées d'isolation électrique s'étendant dans le substrat depuis la première face jusqu'à la deuxième face, chaque tranchée séparant des première et deuxième portions du substrat, chaque tranchée comprenant au moins des première et deuxième couches isolantes électriquement du premier matériau isolant électriquement s'étendant de la première face à la deuxième face, des première et deuxième couches intermédiaires, s'étendant de la première face à la deuxième face, du premier matériau de remplissage et une troisième couche isolante électriquement s'étendant de la première face à la deuxième face, du premier matériau isolant électriquement ou du deuxième matériau isolant électriquement, la première couche isolante électriquement étant en contact avec la première couche intermédiaire, la deuxième couche isolante électriquement étant en contact avec la deuxième couche intermédiaire, et la troisième couche isolante électriquement étant interposée entre les première et deuxième couches intermédiaires.

Selon un mode de réalisation, le procédé comprend, en outre, avant l'étape d'amincissement, le dépôt d'une deuxième couche intermédiaire, du premier matériau de remplissage ou d'un deuxième matériau de remplissage différent du premier matériau de remplissage, au moins dans chaque ouverture au contact de la deuxième couche isolante électriquement, chaque tranchée délimitée à l'étape d'amincissement comprenant, en outre, une quatrième portion isolante électriquement, s'étendant de la première face à la deuxième face, du même matériau que la troisième portion isolante électriquement et au moins une troisième portion intermédiaire, s'étendant de la première face à la deuxième face, du premier matériau de remplissage ou du deuxième matériau de remplissage, la troisième portion isolante électriquement étant en contact avec la première portion intermédiaire, la quatrième portion isolante électriquement étant en contact avec la deuxième portion intermédiaire, et la troisième portion intermédiaire étant interposée entre les troisième et quatrième portions isolantes électriquement.

Selon un mode de réalisation, le procédé comprend, en outre, avant l'étape d'amincissement, le dépôt d'une troisième couche isolante électriquement, du premier matériau isolant électriquement, du deuxième matériau isolant électriquement ou d'un troisième matériau isolant électriquement différent des premier et deuxième matériaux isolants électriquement, au moins dans chaque ouverture, au contact de la deuxième couche intermédiaire, chaque tranchée délimitée à l'étape d'amincissement comprenant, en outre, une quatrième portion intermédiaire, s'étendant de la première face à la deuxième face, du même matériau que la troisième portion intermédiaire, et au moins une cinquième portion isolante électriquement, s'étendant de la première face à la deuxième face, du premier matériau isolant électriquement, du deuxième matériau isolant électriquement ou du troisième matériau isolant électriquement, la troisième portion intermédiaire étant en contact avec la troisième portion isolante électriquement, la quatrième portion intermédiaire étant en contact avec la quatrième portion isolante électriquement et la cinquième portion isolante électriquement étant interposée entre les troisième et quatrième portions intermédiaires.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1 et 2, décrites précédemment, sont des vues en coupe, partielles et schématiques, d'un exemple de circuit électronique comprenant des tranchées d'isolation électrique selon l'art antérieur ;
les figures 3, 4 et 5 sont des vues en coupe, partielles et schématiques, de modes de réalisation de circuits électroniques comprenant des tranchées d'isolation électrique ; et
les figures 6A à 6G représentent les structures obtenues à des étapes successives d'un mode de réalisation d'un procédé de fabrication du circuit électronique représenté en figure 3.

### Description détaillée

De mêmes éléments ont été désignés par de mêmes références aux différentes figures. En outre, comme cela est usuel dans la représentation des circuits intégrés, les figures ne sont pas tracées à l'échelle. Par souci de clarté, seuls les éléments qui sont utiles à la compréhension des modes de réalisation décrits ont été représentés et sont détaillés. Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures. Sauf précision contraire, les expressions "approximativement", "sensiblement", "environ" et "de l'ordre de" signifient à 10 % près, de préférence à 5 % près. Dans la suite de la description, on appelle "matériau isolant électriquement" un matériau dont la résistivité est supérieure à 10³ Ω.m et on appelle "matériau semiconducteur" un matériau dont la résistivité électrique est comprise entre et 0,1 Ω.m et 10³ Ω.m.

Selon un mode de réalisation, chaque tranchée d'isolation électrique est formée d'une succession de portions isolantes électriquement, s'étendant entre les deux faces du substrat, alternées avec des portions de remplissage, également appelées portions intermédiaires, s'étendant entre les deux faces du substrat, chaque portion de remplissage étant prise en sandwich entre deux portions isolantes. Chaque tranchée d'isolation électrique comprend au minimum trois portions isolantes et deux portions de remplissage. La tenue en tension de la tranchée est ainsi augmentée. Depuis chaque paroi latérale 18A, 18B, la tranchée comprend donc successivement une portion isolante, une portion de remplissage, une portion isolante, etc. Si on numérote chaque portion isolante depuis chaque paroi latérale de la tranchée jusqu'au centre de la tranchée, les portions isolantes de même rang sont composées du même matériau isolant. De même, si on numérote chaque portion de remplissage depuis chaque paroi latérale de la tranchée jusqu'au centre de la tranchée, les portions de remplissage de même rang sont composées du même matériau de remplissage.

La figure 3 est une vue analogue à la figure 2 et représente un mode de réalisation d'un circuit électronique 30 dans lequel chaque tranchée comprend trois portions isolantes électriquement. Le circuit électronique 30 comprend l'ensemble des éléments du circuit électronique 5 représenté en figure 2, chaque tranchée 12, 14 comprenant, en outre, une portion 32 isolante électriquement située entre les portions isolantes 19A, 19B et s'étendant de la face 8 à la face 10. La portion 32 délimite des portions 34A, 34B d'un matériau de remplissage, la portion 34A étant située entre la portion isolante 19A et la portion isolante 32, au contact de la portion isolante 19A et de la portion isolante 32 et la portion 34B étant située entre la portion isolante 19B et la portion isolante 32, au contact de la portion isolante 19B et de la portion isolante 32. Les deux portions 34A, 34B sont d'un même matériau différent du matériau du substrat 6 notamment par son procédé d'obtention.

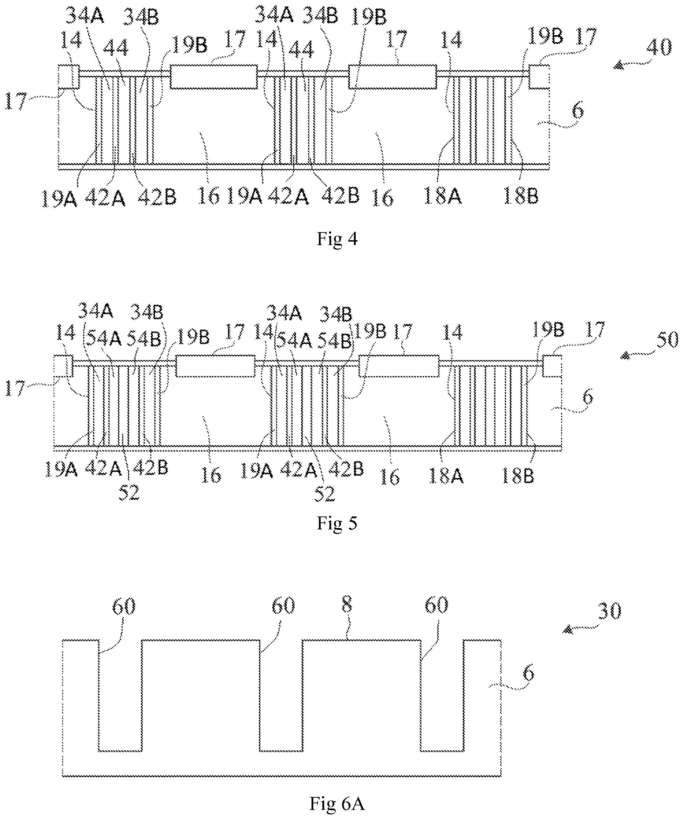

La figure 4 est une vue analogue à la figure 2 et représente un mode de réalisation d'un circuit électronique 40 dans lequel chaque tranchée comprend quatre portions isolantes électriquement. Le circuit électronique 40 comprend l'ensemble des éléments du circuit électronique 5 représenté en figure 2, chaque tranchée 12, 14 comprenant, en outre, des portions 42A, 42B isolantes électriquement situées entre les portions 34A, 34B du matériau de remplissage et s'étendant de la face 8 à la face 10, la portion isolante 42A étant au contact de la portion 34A et la portion isolante 42B étant au contact de la portion 34B. Les portions 42A, 42B délimitent une portion de remplissage 44, située entre la portion isolante 42A et la portion isolante 42B et au contact des portions isolantes 42A et 42B. La portion 44 est en un deuxième matériau de remplissage qui peut être identique ou différent du premier matériau de remplissage.

La figure 5 est une vue analogue à la figure 4 et représente un mode de réalisation d'un circuit électronique 50 dans lequel chaque tranchée comprend cinq portions isolantes électriquement. Le circuit électronique 50 comprend l'ensemble des éléments du circuit électronique 40 représenté en figure 4, chaque tranchée 12, 14 comprenant, en outre, une portion 52 isolante électriquement située entre les portions isolantes 42A et 42B et s'étendant de la face 8 à la face 10. La portion isolante 52 délimite des portions de remplissage 54A, 54B, la portion 54A étant située entre la portion isolante 42A et la portion isolante 52, au contact des portions isolantes 42A et 52, et la portion 54B étant située entre la portion isolante 42B et la portion isolante 52, au contact des portions isolantes 52 et 42B. Les deux portions 54A et 54B sont d'un même matériau de remplissage, identique ou différent du matériau de remplissage composant les portions 34A et 34B.

L'épaisseur E de chaque tranchée 12, 14 est comprise entre 0,5 µm et 10 µm, par exemple environ 2 µm. Le rapport entre l'épaisseur E de chaque tranchée 12, 14 et l'épaisseur du substrat 6 est inférieur à 50, de préférence inférieur à 30. L'épaisseur de chaque portion isolante 19A, 19B, 32, 42A, 42B, 52, mesurées dans un plan parallèle à la face 8, est comprise entre 10 et 2000 nm, de préférence entre 100 et 600 nm, par exemple environ 200 nm. Le rapport entre l'épaisseur de chaque portion isolante 19A, 19B, 32, 42A, 42B, 52 et l'épaisseur de chaque tranchée 12, 14 est inférieure à 0,2, de préférence à 0,1. L'épaisseur de chaque portion de remplissage 34A, 34B, 44, 54A, 54B, mesurée dans un plan parallèle à la face 8, est comprise entre 235 nm et 2000 nm, de préférence entre 500 nm et 1000 nm, par exemple environ 750 nm. L'épaisseur du substrat 6 est comprise entre 2 µm et 500 µm, par exemple environ 60 µm, à la fin du procédé de fabrication du circuit optoélectronique.

Le substrat 6 peut correspondre à une structure monobloc ou correspondre à une couche recouvrant un support constitué d'un autre matériau. Le substrat 6 est de préférence un substrat semiconducteur, par exemple un substrat en silicium, en germanium, en carbure de silicium, en un composé III-V, tel que du GaN ou du GaAs, ou un substrat en ZnO. De préférence, le substrat 6 est un substrat de silicium monocristallin. De préférence, il s'agit d'un substrat semiconducteur compatible avec les procédés de fabrication mis en oeuvre en microélectronique. Le substrat 6 peut correspondre à une structure multicouches de type silicium sur isolant, également appelée SOI (sigle anglais pour Silicon On Insulator). Le substrat 6 peut être fortement dopé, faiblement dopé ou non dopé.

Chaque portion isolante 19A, 19B, 32, 42A, 42B, 52 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (notamment de formule générale SiOₓN_{y}, par exemple du Si₂ON₂) ou en un matériau ayant une constante diélectrique inférieure, de préférence de 30 % à 50 %, à la constante diélectrique de l'oxyde de silicium, notamment le dioxyde de silicium dopé au fluor, le dioxyde de silicium dopé au carbone, le dioxyde de silicium poreux ou le dioxyde de silicium dopé au carbone poreux.

Chaque portion isolante 19A, 19B, 32, 42A, 42B, 52 peut être formée par un procédé de dépôt, notamment un procédé de dépôt chimique en phase vapeur (CVD, sigle anglais pour Chemical Vapor Déposition), notamment un procédé de dépôt chimique en phase vapeur assisté par plasma ou PECVD (sigle anglais pour Plasma-Enhanced Chemical Vapor Déposition), ou encore SACVD (sigle anglais pour Surface Activated Chemical Vapor Déposition) par exemple à des températures comprises entre 50 et 700 °C. Chaque portion isolante 19A, 19B, 32, 42A, 42B, 52 peut être formée par oxydation thermique, notamment à des températures comprises entre 700 °C et 1200 °C, de préférence entre 1000 °C et 1100 °C. Des procédés d'oxydation thermique sèche ou humide peuvent être utilisés. De préférence, chaque portion isolante 19A, 19B, 32, 42A, 42B, 52 est formée par oxydation thermique.

Chaque portion de remplissage 34A, 34B, 44, 54A, 54B est en un matériau de remplissage. Le matériau de remplissage peut correspondre au matériau composant le substrat 6, notamment sous une forme polycristalline, ou être un autre matériau que celui composant le substrat. Il a pour premier rôle d'assurer la cohérence mécanique du circuit optoélectronique. De façon plus générale, le matériau de remplissage 20 peut correspondre à un matériau isolant électriquement, semiconducteur ou conducteur électrique. Les portions de remplissage 34A, 34B, 44, 54A, 54B sont, par exemple, en silicium, en germanium, en carbure de silicium, en un composé III-V, tel que du GaN, du InP ou du GaAs, en un composé II-VI, par exemple du ZnO, en tungstène (W), en cuivre (Cu), en verre à base d'oxydes, notamment d'oxyde de silicium (SiO₂), d'oxyde de sodium (Na₂O), d'oxyde de calcium (CaO) ou d'oxyde de baryum (B₂O₃), ou en un matériau à base organique comme le polyimide, les époxy, le polyuréthane, le polynorbornènes, le benzocyclobutène, le polytétrafluoroéthylène (PTFE, notamment le Téflon), le polyarylène, les éthers, le parylène, l'hydrogènesilsesquioxane (HSQ) et le méthylsilsesquioxane (MSQ). De préférence, chaque portion 34A, 34B, 44, 54A, 54B est en silicium polycristallin. De préférence, chaque portion 34A, 34B, 44, 54A, 54B est en un matériau compatible avec les procédés de fabrication mis en oeuvre en microélectronique. Chaque portion 34A, 34B, 44, 54A, 54B peut être fortement dopé, faiblement dopé ou non dopé.

Les figures 6A à 6G sont des vues en coupe, partielles et schématiques, de structures obtenues à des étapes successives d'un mode de réalisation d'un procédé de fabrication de la tranchée d'isolation électrique du circuit électronique 30 de la figure 3.

La figure 6A représente la structure obtenue après la formation, pour chaque tranchée, d'une ouverture 60 s'étendant dans le substrat 6 depuis la face 8 du substrat 6 à l'emplacement souhaité de la tranchée. L'épaisseur initiale du substrat 6 est supérieure à l'épaisseur finale souhaitée du substrat 6. La largeur de l'ouverture 60, mesurée dans un plan parallèle à la face 8, est légèrement inférieure à la largeur E souhaitée de la tranchée et la profondeur de l'ouverture 60 est supérieure à la profondeur finale souhaitée de la tranchée. Chaque ouverture 60 peut être formée par des étapes de photolithographie, comprenant le dépôt d'une couche de résine sur la face supérieure, la formation d'une ouverture dans la couche de résine sur l'emplacement souhaité de l'ouverture 60, la gravure de l'ouverture 60 dans le substrat 6 dans le prolongement de l'ouverture formée dans la couche de résine et le retrait de la couche de résine. A titre d'exemple, chaque ouverture 60 peut être formée par une gravure sèche. A titre de variante, comme cela est connu dans l'état de l'art, le dépôt préalable d'une couche d'arrêt dite "masque dur" peut être utilisé en plus de la résine de photolithographie.

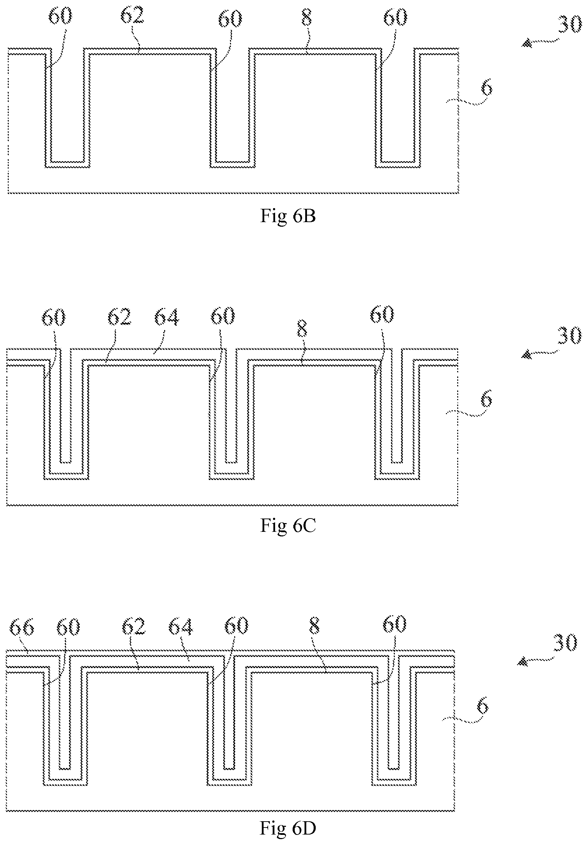

La figure 6B représente la structure obtenue après la formation d'une couche isolante électriquement 62 sur la face 8 et dans l'ouverture 60. Selon un mode de réalisation, la couche isolante 62 est réalisée par une étape d'oxydation thermique. L'étape d'oxydation thermique est réalisée par exemple entre 1000 °C et 1100 °C. Le procédé d'oxydation thermique entraîne la transformation d'une partie du substrat 6 en un oxyde et donc un déplacement de la face 8. A titre de variante, la couche isolante 62 peut être formée par un procédé du type dépôt chimique en phase vapeur (CVD, sigle anglais pour Chemical Vapor Déposition), notamment le dépôt chimique en phase vapeur assisté par plasma (PECVD, sigle anglais pour Plasma-Enhanced Chemical Vapor Déposition), le dépôt chimique en phase vapeur à basse pression (SACVD, sigle anglais pour SubAthmospheric Chemical Vapor Déposition), ou par d'autres techniques de dépôt ou de croissance comme l'oxydation thermique. La couche 62 peut être en l'un des matériaux décrits précédemment pour les portions isolantes 19A, 19B, 32, 42A, 42B, 52.

La figure 6C représente la structure obtenue après le dépôt sur l'ensemble de la structure d'une couche 64 d'un matériau de remplissage recouvrant la couche 62, notamment dans chaque ouverture 60. L'épaisseur de la couche 64 est choisie de façon que les ouvertures 60, recouvertes de la couche isolante 62, ne soient pas complètement remplies du matériau de remplissage. La couche 64 peut être formée par CVD ou PVD (sigle anglais pour Physical Vapor Déposition), dépôt en phase liquide, dépôt par les techniques d'impression pour les matériaux organiques, telles que la tournette (ou spin-coating en anglais), sérigraphie, spray ou jet d'encre. La couche 64 peut être en l'un des matériaux décrits précédemment pour les portions de remplissage 34A, 34B, 44, 54A, 54B.

La figure 6D représente la structure obtenue après la formation d'une couche isolante électriquement 66, par exemple par l'un des procédés décrits précédemment pour la formation de la couche isolante 62, notamment par une étape d'oxydation thermique, sur la couche 64 et remplissant complètement chaque ouverture 60. Lorsqu'un procédé d'oxydation thermique est mis en oeuvre, celui-ci entraîne la transformation d'une partie de la couche 64 en un oxyde. La couche 66 peut être en l'un des matériaux décrits précédemment pour les portions isolantes 19A, 19B, 32, 42A, 42B, 52. A titre de variante, la formation de la couche isolante électriquement 66 peut être réalisée après une étape de gravure des parties de la couche 64 situées à l'extérieur des ouvertures 60.

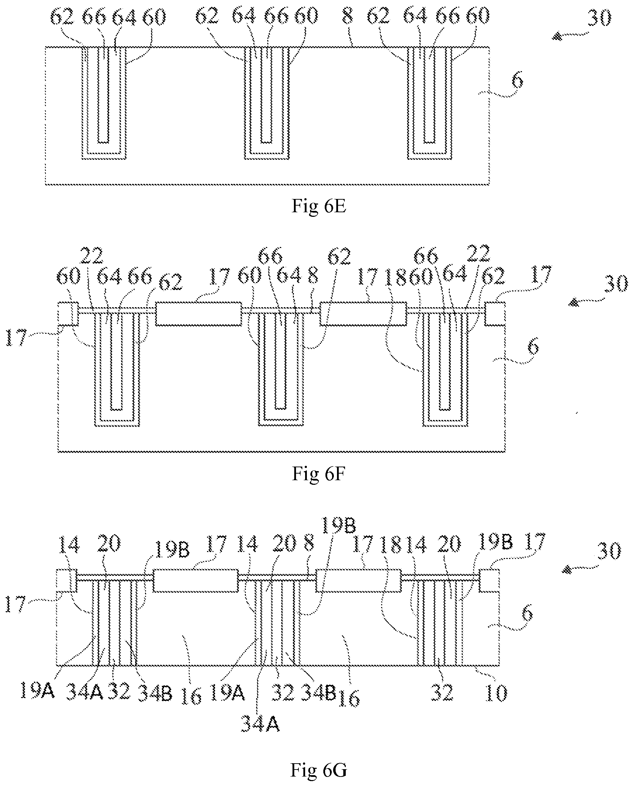

La figure 6E représente la structure obtenue après la gravure des parties de la couche isolante 62, de la couche du matériau de remplissage 64 et de la couche isolante 66 à l'extérieur de chaque ouverture 60 jusqu'à la face 8 pour ne conserver que les parties de la couche isolante 62, de la couche du matériau de remplissage 64 et de la couche isolante 66 dans chaque ouverture 60. L'étape de gravure peut comprendre une étape de polissage mécano-chimique ou CMP (sigle anglais pour Chemical Mechanical Polishing) de la couche isolante 62, de la couche du matériau de remplissage 64 et de la couche isolante 66 jusqu'à la face 8, et/ou des étapes de gravure chimique sèche ou humide, ou encore par gravure physique de type faisceaux d'ions.

La figure 6F représente la structure obtenue après la réalisation d'étapes supplémentaires du côté de la face 8, comprenant par exemple la formation des composants électroniques 17 et de la couche isolante 22.

La figure 6G représente la structure obtenue après une étape d'amincissement du substrat 6 jusqu'à atteindre la couche isolante 66 dans les ouvertures 60. L'étape d'amincissement peut comprendre des étapes de meulage (Grinding en anglais), des étapes de CMP et/ou encore des étapes de gravure sèche ou humide. Cette étape entraîne la délimitation des portions isolantes 19A, 19B, des portions de remplissage 34A, 34B et de la portion isolante 32. L'étape d'amincissement du substrat 6 peut requérir l'utilisation d'un support, également appelé poignée, fixée de façon temporaire ou permanente au substrat 6, du côté de la face 8 et permettant la manipulation du substrat 6.

Un mode de réalisation d'un procédé de fabrication des circuits optoélectroniques 40 et 50 comprend les étapes décrites précédemment en relation avec les figures 6A à 6G à la différence que les étapes 6B et 6C sont répétées, un fois ou plus d'une fois, pour former la succession de couches isolantes et de couches de remplissage qui, après l'étape d'amincissement du substrat, conduit à la structure souhaitées des tranchées d'isolation électrique.

Bien que dans les modes de réalisation décrits précédemment, les tranchées 12 soient représentées perpendiculaires aux tranchées 14, il est clair que l'orientation des tranchées peut être différente. A titre d'exemple, les portions 16 peuvent avoir, en vue de dessus, une section hexagonale. En outre, divers modes de réalisation avec diverses variantes ont été décrits ci-dessus. On note que divers éléments de ces divers modes de réalisation et variantes peuvent être combinés.

## Revendications

1. Circuit électronique (30 ; 40 ; 50) comprenant un substrat (6) semiconducteur ayant des première et deuxième faces (8, 10) opposées et des tranchées (12, 14) d'isolation électrique s'étendant dans le substrat depuis la première face jusqu'à la deuxième face, les tranchées délimitant des rangées de portions du substrat, isolées électriquement les unes des autres, chaque tranchée comprenant :
au moins des première et deuxième portions isolantes électriquement (19A, 19B) d'un premier matériau isolant électriquement s'étendant de la première face à la deuxième face,
des première et deuxième portions intermédiaires (34A, 34B), s'étendant de la première face à la deuxième face, en un premier matériau de remplissage différent du premier matériau isolant électriquement, et
une troisième portion isolante électriquement (32 ; 42A, 42B ; 52), s'étendant de la première face à la deuxième face, du premier matériau isolant électriquement ou d'un deuxième matériau isolant électriquement différent du premier matériau isolant électriquement,
la première portion isolante électriquement (19A) étant en contact avec la première portion intermédiaire (34A), la deuxième portion isolante électriquement (19B) étant en contact avec la deuxième portion intermédiaire (34B), et la troisième portion isolante électriquement (32 ; 42A, 42B ; 52) étant interposée entre les première et deuxième portions intermédiaires (34A, 34B).

2. Circuit électronique selon la revendication 1, dans lequel chaque tranchée (14) comprend en outre :
une quatrième portion isolante électriquement (42B), s'étendant de la première face (8) à la deuxième face (10), du même matériau que la troisième portion isolante électriquement (42A), et
au moins une troisième portion intermédiaire (44 ; 54A, 54B), s'étendant de la première face à la deuxième face, du premier matériau de remplissage ou d'un deuxième matériau de remplissage différent du premier matériau de remplissage,
la troisième portion isolante électriquement (42A) étant en contact avec la première portion intermédiaire (34A), la quatrième portion isolante électriquement (42B) étant en contact avec la deuxième portion intermédiaire (34B), et la troisième portion intermédiaire (44 ; 54A, 54B) étant interposée entre les troisième et quatrième portions isolantes électriquement (42A, 42B).

3. Circuit électronique selon la revendication 2, dans lequel chaque tranchée (14) comprend en outre :
une quatrième portion intermédiaire (54B), s'étendant de la première face (8) à la deuxième face (10), du même matériau que la troisième portion intermédiaire (54A), et
au moins une cinquième portion isolante électriquement (52), s'étendant de la première face à la deuxième face, du premier matériau isolant électriquement, du deuxième matériau isolant électriquement ou d'un troisième matériau isolant électriquement différent des premier et deuxième matériaux isolants électriquement,
la troisième portion intermédiaire (54A) étant en contact avec la troisième portion isolante électriquement (42A), la quatrième portion intermédiaire (54B) étant en contact avec la quatrième portion isolante électriquement (42B), et la cinquième portion isolante électriquement (52) étant interposée entre les troisième et quatrième portions intermédiaires (54A, 54B).

4. Circuit électronique selon l'une quelconque des revendications 1 à 3, dans lequel le premier matériau isolant électriquement est choisi dans le groupe comprenant l'oxyde de silicium, le nitrure de silicium, l'oxynitrure de silicium ou est un matériau ayant une constante diélectrique inférieure, d'au moins 30 %, à la constante diélectrique de l'oxyde de silicium, notamment le dioxyde de silicium dopé au fluor, le dioxyde de silicium dopé au carbone, le dioxyde de silicium poreux ou le dioxyde de silicium dopé au carbone poreux.

5. Circuit électronique selon l'une quelconque des revendications 1 à 4, dans lequel le premier matériau de remplissage est choisi parmi le groupe comprenant le silicium, le germanium, le carbure de silicium, les composés III-V, les composés II-VI, le tungstène, le cuivre, les verres à base d'oxydes, les matériaux à base organique ou un mélange d'au moins deux de ces composés.

6. 7. Circuit électronique selon l'une quelconque des revendications 1 à 5, dans lequel l'épaisseur du substrat (6) est comprise entre 2 um et 500 um.

7. Circuit électronique selon l'une quelconque des revendications 1 à 6,
dans lequel l'épaisseur des première, deuxième et troisième portions isolantes électriquement (19A, 19B, 32 ; 42A, 42B, 52) est comprise entre 10 nm et 500 nm.

8. Circuit électronique selon l'une quelconque des revendications 1 à 6,
dans lequel l'épaisseur des première et deuxième portions intermédiaires (34A, 34B) est comprise entre 235 nm et 2000 nm.

9. 10. Procédé de fabrication d'un circuit électronique (30 ; 40 ; 50), comprenant les étapes successives suivantes :
prévoir un substrat (6) semiconducteur ayant des première et deuxième faces (8, 10) opposées ;
former des ouvertures (60) dans le substrat depuis la première face sur une partie de l'épaisseur du substrat ;
déposer une première couche isolante électriquement (62) d'un premier matériau isolant électriquement au moins dans chaque ouverture ;
déposer une première couche intermédiaire (64) d'un premier matériau de remplissage différent du premier matériau isolant électriquement au moins dans chaque ouverture au contact de la première couche isolante électriquement ;
déposer une deuxième couche isolante électriquement (66) du premier matériau isolant électriquement ou d'un deuxième matériau isolant électriquement différent du premier matériau isolant électriquement au moins dans chaque ouverture au contact de la première couche intermédiaire ; et
amincir le substrat par la deuxième face pour rapprocher la deuxième face de la première face jusqu'à atteindre au moins la deuxième couche isolante électriquement, délimitant ainsi des tranchées (12, 14) d'isolation électrique s'étendant dans le substrat depuis la première face jusqu'à la deuxième face, les tranchées délimitant des rangées de portions du substrat, isolées électriquement les unes des autres, chaque tranchée comprenant au moins des première et deuxième couches isolantes électriquement (19A, 19B) du premier matériau isolant électriquement s'étendant de la première face à la deuxième face, des première et deuxième couches intermédiaires (34A, 34B), s'étendant de la première face à la deuxième face, du premier matériau de remplissage et une troisième couche isolante électriquement (32 ; 42A, 42B ; 52) s'étendant de la première face à la deuxième face, du premier matériau isolant électriquement ou du deuxième matériau isolant électriquement, la première couche isolante électriquement (19A) étant en contact avec la première couche intermédiaire (34A), la deuxième couche isolante électriquement (19B) étant en contact avec la deuxième couche intermédiaire (34B), et la troisième couche isolante électriquement (32 ; 42A, 42B ; 52) étant interposée entre les première et deuxième couches intermédiaires (34A, 34B).

10. Procédé de fabrication selon la revendication 9, comprenant, en outre, avant l'étape d'amincissement, le dépôt d'une deuxième couche intermédiaire, du premier matériau de remplissage ou d'un deuxième matériau de remplissage différent du premier matériau de remplissage, au moins dans chaque ouverture au contact de la deuxième couche isolante électriquement (66), chaque tranchée (12, 14) délimitée à l'étape d'amincissement comprenant, en outre, une quatrième portion isolante électriquement (42B), s'étendant de la première face (8) à la deuxième face (10), du même matériau que la troisième portion isolante électriquement (42A) et au moins une troisième portion intermédiaire (44 ; 54A, 54B), s'étendant de la première face à la deuxième face, du premier matériau de remplissage ou du deuxième matériau de remplissage, la troisième portion isolante électriquement (42A) étant en contact avec la première portion intermédiaire (34A), la quatrième portion isolante électriquement (42B) étant en contact avec la deuxième portion intermédiaire (34B), et la troisième portion intermédiaire (44 ; 54A, 54B) étant interposée entre les troisième et quatrième portions isolantes électriquement (42A, 42B).

11. Procédé de fabrication selon la revendication 9, comprenant, en outre, avant l'étape d'amincissement, le dépôt d'une troisième couche isolante électriquement, du premier matériau isolant électriquement, du deuxième matériau isolant électriquement ou d'un troisième matériau isolant électriquement différent des premier et deuxième matériaux isolants électriquement, au moins dans chaque ouverture, au contact de la deuxième couche intermédiaire, chaque tranchée (12, 14) délimitée à l'étape d'amincissement comprenant, en outre, une quatrième portion intermédiaire (54B), s'étendant de la première face (8) à la deuxième face (10), du même matériau que la troisième portion intermédiaire (54A), et au moins une cinquième portion isolante électriquement (52), s'étendant de la première face à la deuxième face, du premier matériau isolant électriquement, du deuxième matériau isolant électriquement ou du troisième matériau isolant électriquement, la troisième portion intermédiaire (54A) étant en contact avec la troisième portion isolante électriquement (42A), la quatrième portion intermédiaire (54B) étant en contact avec la quatrième portion isolante électriquement (42B) et la cinquième portion isolante électriquement (52) étant interposée entre les troisième et quatrième portions intermédiaires (54A, 54B).

## Patentansprüche

1. Elektronische Schaltung (30; 40; 50) aufweisend ein Halbleitersubstrat (6), mit ersten und eine zweiten entgegengesetzten Oberflächen (8, 10) und elektrisch isolierende Gräben (12, 14) aufweist, die sich in dem Substrat von der ersten Oberfläche zu der zweiten Oberfläche erstrecken, wobei die Gräben Reihen von Abschnitten des Substrats begrenzen, die elektrisch voneinander isoliert sind, wobei jeder Graben Folgendes aufweist:
mindestens erste und zweite elektrisch isolierende Abschnitte (19A, 19B) aus einem ersten elektrisch isolierenden Material, die sich von der ersten Oberfläche zur zweiten Oberfläche erstrecken,
erste und zweite Zwischenabschnitte (34A, 34B), die sich von der ersten Oberfläche zur zweiten Oberfläche erstrecken und aus einem ersten Füllmaterial hergestellt sind, das sich von dem ersten elektrisch isolierenden Material unterscheidet, und
einen dritten elektrisch isolierenden Abschnitt (32; 42A, 42B; 52), der sich von der ersten Oberfläche zu der zweiten Oberfläche erstreckt und aus dem ersten elektrisch isolierenden Material oder aus einem zweiten elektrisch isolierenden Material, das sich von dem ersten elektrisch isolierenden Material unterscheidet, hergestellt ist,
wobei der erste elektrisch isolierende Abschnitt (19A) mit dem ersten Zwischenabschnitt (34A) in Kontakt steht, der zweite elektrisch isolierende Abschnitt (19B) mit dem zweiten Zwischenabschnitt (34B) in Kontakt steht und der dritte elektrisch isolierende Abschnitt (32; 42A, 42B; 52) zwischen den ersten und zweiten Zwischenabschnitten (34A, 34B) angeordnet ist.

2. Elektronische Schaltung nach Anspruch 1, wobei jeder Graben (14) ferner folgendes aufweist:
einen vierten elektrisch isolierenden Abschnitt (42B), der sich von der ersten Oberfläche (8) zur zweiten Oberfläche (10) erstreckt und aus dem gleichen Material wie der dritte elektrisch isolierende Abschnitt (42A) hergestellt ist, und mindestens einen dritten Zwischenabschnitt (44; 54A, 54B), der sich von der ersten Oberfläche zur zweiten Oberfläche erstreckt und aus dem ersten Füllmaterial oder aus einem zweiten, vom ersten Füllmaterial verschiedenen Füllmaterial hergestellt ist,
wobei der dritte elektrisch isolierende Abschnitt (42A) in Kontakt mit dem ersten Zwischenabschnitt (34A) steht, der vierte elektrisch isolierende Abschnitt (42B) in Kontakt mit dem zweiten Zwischenabschnitt (34B) steht und der dritte Zwischenabschnitt (44; 54A, 54B) zwischen den dritten und vierten elektrisch isolierenden Abschnitten (42A, 42B) angeordnet ist.

3. Elektronische Schaltung nach Anspruch 2, wobei jeder Graben (14) ferner folgendes aufweist:
einen vierten Zwischenabschnitt (54B), der sich von der ersten Oberfläche (8) zu der zweiten Oberfläche (10) erstreckt und aus demselben Material wie der dritte Zwischenabschnitt (54A) hergestellt ist, und
mindestens einen fünften elektrisch isolierenden Abschnitt (52), der sich von der ersten Oberfläche zur zweiten Oberfläche erstreckt und aus dem ersten elektrisch isolierenden Material, aus dem zweiten elektrisch isolierenden Material oder aus einem dritten elektrisch isolierenden Material, das sich von dem ersten und dem zweiten elektrisch isolierenden Material unterscheidet, hergestellt ist,
wobei der dritte Zwischenabschnitt (54A) in Kontakt mit dem dritten elektrisch isolierenden Abschnitt (42A) steht, der vierte Zwischenabschnitt (54B) in Kontakt mit dem vierten elektrisch isolierenden Abschnitt (42B) steht und der fünfte elektrisch isolierende Abschnitt (52) zwischen den dritten und vierten Zwischenabschnitten (54A, 54B) angeordnet ist.

4. Elektronische Schaltung nach einem der Ansprüche 1 bis 3, wobei das erste elektrisch isolierende Material aus der Gruppe ausgewählt ist, die Siliziumoxid, Siliziumnitrid, Siliziumoxynitrid aufweist, oder ein Material ist, das eine Dielektrizitätskonstante aufweist, die um mindestens 30 % niedriger ist als die Dielektrizitätskonstante von Siliziumoxid, insbesondere fluordotiertes Siliziumdioxid, kohlenstoffdotiertes Siliziumdioxid, poröses Siliziumdioxid oder poröses kohlenstoffdotiertes Siliziumdioxid.

5. Elektronische Schaltung nach einem der Ansprüche 1 bis 4, wobei das erste Füllmaterial ausgewählt ist aus der Gruppe, die Silizium, Germanium, Siliziumkarbid, III-V-Verbindungen, II-VI-Verbindungen, Wolfram, Kupfer, Oxidgläser, Materialien auf organischer Basis oder eine Mischung aus mindestens zwei dieser Verbindungen aufweist.

6. Elektronische Schaltung nach einem der Ansprüche 1 bis 5, wobei die Dicke des Substrats (6) im Bereich von 2 µm bis 500 µm liegt.

7. Elektronische Schaltung nach einem der Ansprüche 1 bis 6, wobei die Dicke der ersten, zweiten und dritten elektrisch isolierenden Abschnitte (19A, 19B, 32; 42A, 42B, 52) im Bereich von 10 nm bis 500 nm liegt.

8. Elektronische Schaltung nach einem der Ansprüche 1 bis 6, wobei die Dicke der ersten und zweiten Zwischenabschnitte (34A, 34B) im Bereich von 235 nm bis 2.000 nm liegt.

9. Verfahren zur Herstellung einer elektronischen Schaltung (30; 40; 50), das die folgenden aufeinanderfolgenden Schritte aufweist::
Bereitstellen eines Halbleitersubstrats (6) mit ersten und zweiten entgegengesetzten Oberflächen (8, 10);
Ausbilden von Öffnungen (60) in dem Substrat von der ersten Oberfläche aus über einen Teil der Substratdicke;
Abscheiden einer ersten elektrisch isolierenden Schicht (62) aus einem ersten elektrisch isolierenden Material wenigstens in jeder Öffnung;
Abscheiden einer ersten Zwischenschicht (64) aus einem ersten Füllmaterial, das sich von dem ersten elektrisch isolierenden Material unterscheidet, zumindest in jeder Öffnung in Kontakt mit der ersten elektrisch isolierenden Schicht;
Abscheiden einer zweiten elektrisch isolierenden Schicht (66) aus dem ersten elektrisch isolierenden Material oder aus einem zweiten elektrisch isolierenden Material, das sich von dem ersten elektrisch isolierenden Material unterscheidet, zumindest in jeder Öffnung in Kontakt mit der ersten Zwischenschicht; und
Dünner-Machen des Substrats von der zweiten Oberfläche aus, um die zweite Oberfläche näher an die erste Oberfläche zu bringen, um zumindest die zweite elektrisch isolierende Schicht zu erreichen, wodurch elektrisch isolierende Gräben (12, 14) abgegrenzt werden, die sich in dem Substrat von der ersten Oberfläche zu der zweiten Oberfläche erstrecken, wobei die Gräben Reihen von Abschnitten des Substrats abgrenzen, die voneinander elektrisch isoliert sind, wobei jeder Graben mindestens folgendes aufweist: erste und eine zweite elektrisch isolierende Schichten (19A, 19B) aus dem ersten elektrisch isolierenden Material, die sich von der ersten Oberfläche zur zweiten Oberfläche erstrecken, erste und zweite Zwischenschichten (34A, 34B), die sich von der ersten Oberfläche zur zweiten Oberfläche erstrecken und aus dem ersten Füllmaterial bestehen, und eine dritte elektrisch isolierende Schicht (32; 42A, 42B; 52), die sich von der ersten Oberfläche zur zweiten Oberfläche erstreckt und aus dem ersten elektrisch isolierenden Material oder dem zweiten elektrisch isolierenden Material besteht, wobei die erste elektrisch isolierende Schicht (19A) mit der ersten Zwischenschicht (34A) in Kontakt steht, die zweite elektrisch isolierende Schicht (19B) mit der zweiten Zwischenschicht (34B) in Kontakt steht und die dritte elektrisch isolierende Schicht (32; 42A, 42B; 52) zwischen der ersten und der zweiten Zwischenschicht (34A, 34B) angeordnet ist.

10. Herstellungsverfahren nach Anspruch 9, das vor dem Schritt des Dünner-Machen das Abscheiden einer zweite Zwischenschicht aus dem ersten Füllmaterial oder einem zweiten Füllmaterial, das sich von dem ersten Füllmaterial unterscheidet, zumindest in jeder Öffnung in Kontakt mit der zweiten elektrisch isolierenden Schicht (66) aufweist, wobei jeder Graben (12, 14), der bei dem Schritt des Dünner-Machen begrenzt wird, ferner einen vierten elektrisch isolierenden Abschnitt (42B), der sich von der ersten Oberfläche (8) zur zweiten Oberfläche (10) erstreckt und aus demselben Material wie der dritte elektrisch isolierende Abschnitt (42A) hergestellt ist, und mindestens einen dritten Zwischenabschnitt (44; 54A, 54B), der sich von der ersten Oberfläche zur zweiten Oberfläche erstreckt und aus dem ersten Füllmaterial oder dem zweiten Füllmaterial hergestellt ist, aufweist, wobei der dritte elektrisch isolierende Abschnitt (42A) in Kontakt mit dem ersten Zwischenabschnitt (34A) steht, der vierte elektrisch isolierende Abschnitt (42B) in Kontakt mit dem zweiten Zwischenabschnitt (34B) steht und der dritte Zwischenabschnitt (44; 54A, 54B) zwischen den dritten und vierten elektrisch isolierenden Abschnitten (42A, 42B) angeordnet ist.

11. Herstellungsverfahren nach Anspruch 9, das vor dem Schritt des Dünner-Machen das Abscheiden einer dritten elektrisch isolierende Schicht aus dem ersten elektrisch isolierenden Material, aus dem zweiten elektrisch isolierenden Material oder aus einem dritten elektrisch isolierenden Material, das sich von dem ersten und dem zweiten elektrisch isolierenden Material unterscheidet zumindest in jeder Öffnung in Kontakt mit der zweiten Zwischenschicht, aufweist, wobei jeder Graben (12, 14), der bei dem Schritt des Dünner-Machen begrenzt wird, ferner einen vierten Zwischenabschnitt (54B), der sich von der ersten Oberfläche (8) zur zweiten Oberfläche (10) erstreckt und aus demselben Material wie der dritte Zwischenabschnitt (54A) besteht, und mindestens einen fünften elektrisch isolierenden Abschnitt (52) aufweist, der sich von der ersten Oberfläche zu der zweiten Oberfläche erstreckt und aus dem ersten elektrisch isolierenden Material, dem zweiten elektrisch isolierenden Material oder dem dritten elektrisch isolierenden Material hergestellt ist, wobei der dritte Zwischenabschnitt (54A) in Kontakt mit dem dritten elektrisch isolierenden Abschnitt (42A) steht, der vierte Zwischenabschnitt (54B) in Kontakt mit dem vierten elektrisch isolierenden Abschnitt (42B) steht und der fünfte elektrisch isolierende Abschnitt (52) zwischen den dritten und vierten Zwischenabschnitten (54A, 54B) angeordnet ist.

## Claims

1. An electronic circuit (30; 40; 50) comprising a semiconductor substrate (6) having first and second opposite surfaces (8, 10) and electric insulation trenches (12, 14) extending in the substrate from the first surface to the second surface, the trenches delimiting rows of portions of the substrate, electrically insulated from each other, each trench comprising:
at least first and second electrically-insulating portions (19A, 19B) of a first electrically-insulating material extending from the first surface to the second surface,
first and second intermediate portions (34A, 34B) extending from the first surface to the second surface, made of a first filling material different from the first electrically-insulating material, and
a third electrically-insulating portion (32; 42A 42B; 52) extending from the first surface to the second surface, made of the first electrically-insulating material or of a second electrically-insulating material different from the first electrically-insulating material,
the first electrically-insulating portion (19A) being in contact with the first intermediate portion (34A), the second electrically-insulating portion (19B) being in contact with the second intermediate portion (34B), and the third electrically-insulating portion (32; 42A, 42B; 52) being interposed between the first and second intermediate portions (34A, 34B).

2. The electronic circuit of claim 1, wherein each trench (14) further comprises:
a fourth electrically-insulating portion (42B) extending from the first surface (8) to the second surface (10), made of the same material as the third electrically-insulating portion (42A), and
at least one third intermediate portion (44; 54A, 54B) extending from the first surface to the second surface, made of the first filling material or of a second filling material different from the first filling material,
the third electrically-insulating portion (42A) being in contact with the first intermediate portion (34A), the fourth electrically-insulating portion (42B) being in contact with the second intermediate portion (34B), and the third intermediate portion (44; 54A, 54B) being interposed between the third and fourth electrically-insulating portions (42A, 42B).

3. The electronic circuit of claim 2, wherein each trench (14) further comprises:
a fourth intermediate portion (54B) extending from the first surface (8) to the second surface (10), made of the same material as the third intermediate portion (54A), and
at least one fifth electrically-insulating portion (52), extending from the first surface to the second surface, made of the first electrically-insulating material, of the second electrically-insulating material, or of a third electrically-insulating material different from the first and second electrically-insulating materials,
the third intermediate portion (54A) being in contact with the third electrically-insulating portion (42A), the fourth intermediate portion (54B) being in contact with the fourth electrically-insulating portion (42B), and the fifth electrically-insulating portion (52) being interposed between the third and fourth intermediate portions (54A, 54B).

4. The electronic circuit of any of claims 1 to 3, wherein the first electrically-insulating material is selected from the group comprising silicon oxide, silicon nitride, silicon oxynitride, or is a material having a dielectric constant lower by at least 30% than the dielectric constant of silicon oxide, particularly fluorine-doped silicon dioxide, carbon-doped silicon dioxide, porous silicon dioxide, or porous carbon doped silicon dioxide.

5. The electronic circuit of any of claims 1 to 4, wherein the first filling material is selected from the group comprising silicon, germanium, silicon carbide, III-V compounds, II-VI compounds, tungsten, copper, oxide glasses, organic-based materials, or a mixture of at least two of these compounds.

6. The electronic circuit of any of claims 1 to 5, wherein the thickness of the substrate (6) is in the range from 2 um to 500 um.

7. The electronic circuit of any of claims 1 to 6, wherein the thickness of the first, second, and third electrically-insulating portions (19A, 19B, 32; 42A, 42B, 52) is in the range from 10 nm to 500 nm.

8. The electronic circuit of any of claims 1 to 6, wherein the thickness of the first and second intermediate portions (34A, 34B) is in the range from 235 nm to 2,000 nm.

9. A method of manufacturing an electronic circuit (30; 40; 50) comprising the successive steps of:
providing a semiconductor substrate (6) having first and second opposite surfaces (8, 10);
forming openings (60) in the substrate from the first surface across part of the substrate thickness;
depositing a first electrically-insulating layer (62) made of a first electrically-insulating material at least in each opening;
depositing a first intermediate layer (64) made of a first filling material different from the first electrically-insulating material at least in each opening in contact with the first electrically-insulating layer;
depositing a second electrically-insulating layer (66) made of the first electrically-insulating material or of a second electrically-insulating material different from the first electrically-insulating material at least in each opening in contact with the first intermediate layer; and
thinning the substrate from the second surface to bring the second surface closer to the first surface to reach at least the second electrically-insulating layer, thus delimiting electric insulation trenches (12, 14) extending in the substrate from the first surface to the second surface, the trenches delimiting rows of portions of the substrate, electrically insulated from each other, each trench comprising at least first and second electrically-insulating layers (19A, 19B) of the first electrically-insulating material extending from the first surface to the second surface, first and second intermediate layers (34A, 34B) extending from the first surface to the second surface, made of the first filling material, and a third electrically-insulating layer (32; 42A, 42B; 52) extending from the first surface to the second surface, made of the first electrically-insulating material or of the second electrically-insulating material, the first electrically-insulating layer (19A) being in contact with the first intermediate layer (34A), the second electrically-insulating layer (19B) being in contact with the second intermediate layer (34B), and the third electrically-insulating layer (32; 42A, 42B; 52) being interposed between the first and second intermediate layers (34A, 34B).

10. The manufacturing method of claim 9, further comprising, before the thinning step, depositing a second intermediate layer, made of the first filling material or of a second filling material different from the first filling material, at least in each opening in contact with the second electrically-insulating layer (66), each trench (12, 14) delimited at the thinning step further comprising a fourth electrically-insulating portion (42B), extending from the first surface (8) to the second surface (10), made of the same material as the third electrically-insulating portion (42A) and at least a third intermediate portion (44; 54A, 54B) extending from the first surface to the second surface, made of the first filling material or of the second filling material, the third electrically-insulating portion (42A) being in contact with the first intermediate portion (34A), the fourth electrically-insulating portion (42B) being in contact with the second intermediate portion (34B), and the third intermediate portion (44; 54A, 54B) being interposed between the third and fourth electrically-insulating portions (42A, 42B).

11. The manufacturing method of claim 9, further comprising, before the thinning step, depositing a third electrically-insulating layer, made of the first electrically-insulating material, of the second electrically-insulating material, or of a third electrically-insulating material different from the first and second electrically-insulating materials, at least in each opening, in contact with the second intermediate layer, each trench (12, 14) delimited at the thinning step further comprising a fourth intermediate portion (54B), extending from the first surface (8) to the second surface (10), made of the same material as the third intermediate portion (54A), and at least a fifth electrically-insulating portion (52), extending from the first surface to the second surface, made of the first electrically-insulating material, of the second electrically-insulating material, or of the third electrically-insulating material, the third intermediate portion (54A) being in contact with the third electrically-insulating portion (42A), the fourth intermediate portion (54B) being in contact with the fourth electrically-insulating portion (42B), and the fifth electrically-insulating portion (52) being interposed between the third and fourth intermediate portions (54A, 54B).
